Europäisches Patentamt

European Patent Office

Office européen des brevets

(11) Publication number: **0 260 059**
**A1**

## (12) EUROPEAN PATENT APPLICATION

(21) Application number: 87307755.6

(22) Date of filing: 02.09.87

(51) Int. Cl.⁴: **H01L 21/285** , H01L 21/82 , H01L 29/72 , H01L 27/08

(30) Priority: 08.09.86 GB 8621536

(43) Date of publication of application:
16.03.88 Bulletin 88/11

(84) Designated Contracting States:
AT BE CH DE ES FR GB GR IT LI LU NL SE

(71) Applicant: BRITISH TELECOMMUNICATIONS plc
British Telecom Centre 81 Newgate Street
London EC1A 7AJ(GB)

(72) Inventor: Welbourn, Anthony David
7 Fishbane Close
Ipswich Suffolk IP3 0SE(GB)
Inventor: Heslop, Christopher John Hedley
7 Viking Heights
Martlesham Woodbridge Suffolk IP12 4RT(GB)

(74) Representative: Roberts, Simon Christopher et al
BRITISH TELECOM Intellectual Property Unit
13th Floor 151, Gower Street
London, WC1E 6BA(GB)

(54) **Self-aligned bipolar fabrication process.**

(57) Bipolar transistors are made by: forming a substitute emitter on a substrate; depositing polysilicon about the substitute emitter; removing the substitute emitter, and implanting the base through the resulting gap; forming dielectric spacers on the sidewalls of the opening; depositing polysilicon in the remains of the opening; and diffusing dopant from the polysilicon into the substrate to form a shallow emitter.

*Fig.5.*

## SELF-ALIGNED BIPOLAR FABRICATION PROCESS

This invention relates to bipolar semiconductor devices and to processes for their fabrication.

Bipolar devices fabricated using known processes are limited in terms of performance by base resistance and capacitance. If the performance of bipolar devices is to be improved, it will be necessary to reduce the area of the base. Considerable attention has already been given to the reduction of base area and the scope for further reduction is severely limited by alignment tolerances for the base and emitter contacts and the limits of resolution of the lithography equipment. Consequently there exists a need for an improved fabrication process which will enable the fabrication of bipolar devices having bases of reduced area without the need to define small device dimensions lithographically.

The present invention seeks to provide an improved fabrication method by means of which the base contact area can be reduced with consequent improvements in device performance.

Throughout this specification the term 'substrate', unless the context clearly requires otherwise, is used to refer to the semiconductor in which the active regions of the transistor are grown and includes any epitaxial semiconductor layers in which active regions are formed.

According to a first aspect of the present invention there is provided a method of fabricating a bipolar transistor comprising emitter, base and collector regions in a semiconductor substrate, the method comprising the steps of:

a) forming a layer of material over the substrate;

b) etching said layer of material to define a body on the substrate corresponding to the region which will subsequently become the base;

c) forming a layer of conductive material on the substrate about and in physical contact with said body;

d) producing base contacts in the substrate under the conductive material adjacent the site of the body;

e) etching to remove the body before or after step (d); and

f) implanting the base region in the substrate through the opening left in the conductive layer by the removal of the body.

Embodiments of the invention will now be described with reference to the accompanying drawings in which:

Figure 1 to Figure 5 are diagrammatic cross-sections through a device according to the invention at various stages of its production;

Figure 6 and Figure 7 are further diagrammatic cross-sections showing details of alternative process steps;

Figure 8 is a further diagrammatic cross-section, showing an alternative process step.

The initial steps in the process are conventional; a silicon wafer (1) is processed to give a buried layer (2), and $n^+$ collector sinker (3) and device isolation (4). The surface of the wafer is also stripped of oxide.

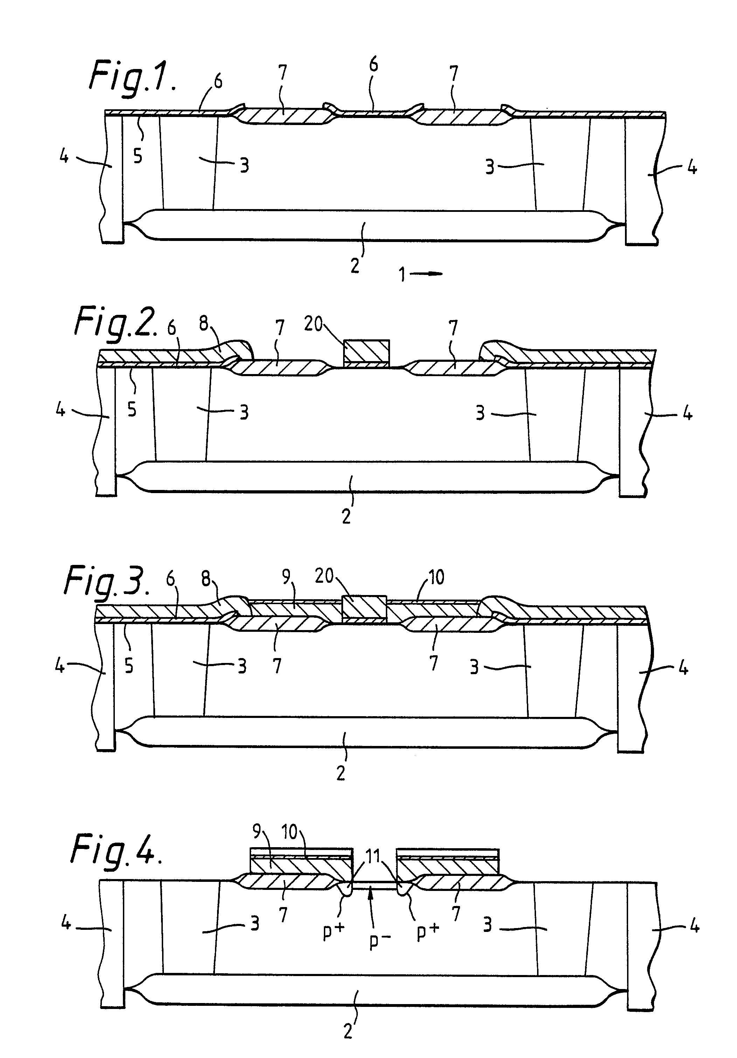

About 10 to 20nm of thermal oxide (5) is grown over the surface of the wafer. Silicon nitride (6) is deposited to a depth of about 200nm over the thermal oxide (5) preferably using low pressure chemical vapour deposition (LPCVD). Plasma etching is then used to remove the nitride layer (6) in the areas surrounding where the base is to be formed. In the nitride free areas, thermal oxide (7) is grown to a depth of about 500nm using a process such as LOCOS. The cross-section at this stage is as shown in Figure 1. Optionally prior to oxidation, the silicon may be etched back so that a fairly level surface results from the oxidation step.

A 0.5-1.0um layer of aluminium or silicon nitride (8) is then deposited. Alternatively a nitride-oxide-nitride "sandwich" may be deposited in place of the thick nitride layer. The advantage of the sandwich is that it avoids the problems of intrinsic stress which are found with thick nitride: the disadvantage is that the 'sandwich' will subsequently be more of a problem to etch.

A substitute emitter (20) is then formed by etching the thick nitride 8 or equivalent underlying nitride (6) and thin oxide (5) to leave a substitute emitter in the form of a nitride island on the silicon surface in the area bordered by the thick thermal oxide (7). The structure at this stage is as shown in Figure 2.

A polysilicon layer (9) is then deposited and etched to planarise the structure. The remaining polysilicon is doped with boron. Optionally silicide (10) may be formed on the surface of the polysilicon by depositing thereon a thin layer of a metal such as Ti, Co, W, Pt, Mo, Ta, and reacting it with the polysilicon. The cross-section at this stage is as shown in Figure 3.

The polysilicon is then oxidised (through the silicide if that is present) to a depth of about 200nm. During the same heating step, boron diffuses from the doped polysilicon into the silicon of the wafer to form $p^+$ contacts (11) for the base. The substitute emitter is then stripped. The base region is implanted through the gap left in the polysilicon by the removal of the substitute emitter. The cross-section at this stage is as shown in Figure 4.

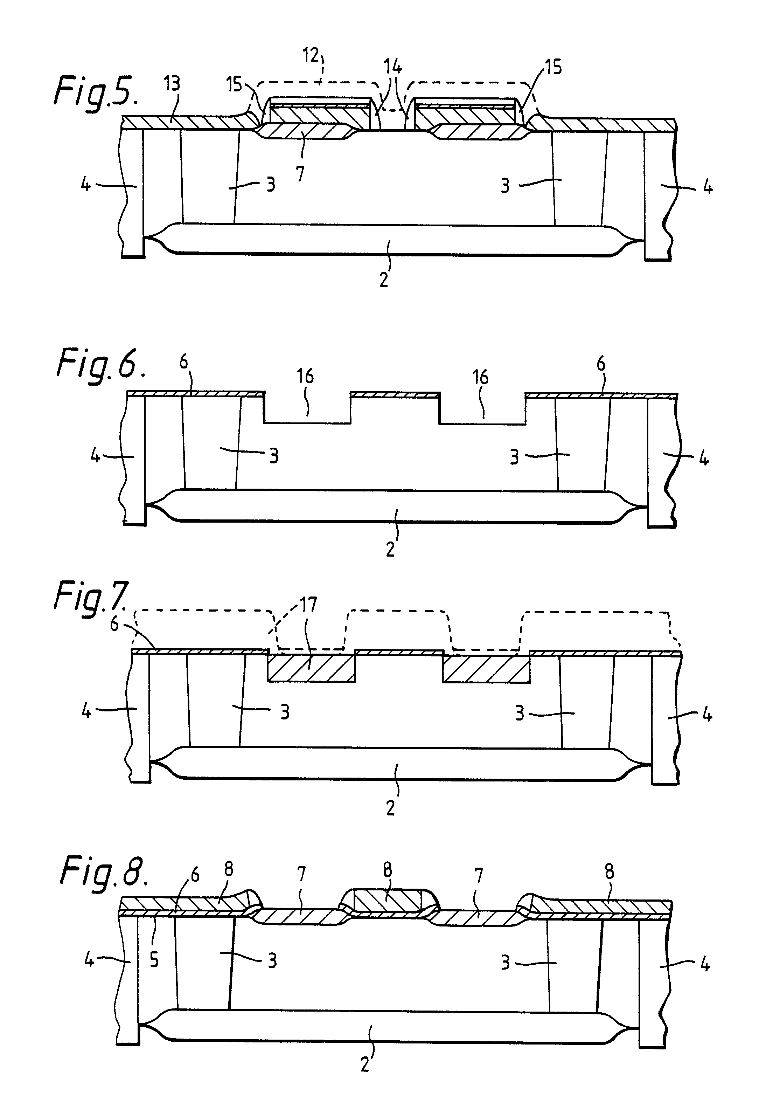

The structure is then coated with a layer of conformal oxide (12) for the field oxide. The conformal oxide (12) is printed to protect the field regions. The oxide (12) is etched, leaving the field oxide regions (13) and spacers (14 and 15) at either side of polysilicon/oxide structures. The cross-section at this stage is as shown in Figure 5.

Polysilicon for the emitter contact is then deposited and doped either during deposition or afterwards with, for example, boron. The emitter contact is then lithographically defined. A very shallow, approx 0.1 um, $n^+$ emitter is then formed by driving the dopant from the polysilicon into the silicon.

A dielectric material such as oxide is then deposited over the whole structure. Contacts for the emitter, base and collector are cut and metal deposited.

A variant of the above described process avoids the need to use thermal oxide layer (7). In place of that oxide growth step, a silicon etch step is used to form an annular pit (16) where the nitride layer (6) was removed as shown in Figure 6. Oxide (17) is then deposited in this pit approximately to the depth of the etch. The deposited oxide 17 is then planarised to give a cross-section such as that shown in Figure 7. The subsequent processing steps are as before.

The disadvantages of relying on a thick thermally grown oxide layer are that the oxide thickness is limited due to "bird's beak" penetration into the base region and time/temperature limitations on diffusion of the buried layer and the collector sinker diffusion.

A further variant of the first described process provides full self-alignment. In this version the thick nitride layer 8 is deposited and the substitute emitter formed before the thin nitride is etched to define the location of the thick thermally oxidised (LOCOS) regions.

Following growth of the thick nitride (8) the substitute emitter is formed by cutting through the thick nitride down to a thin barrier layer of oxide between the thick and thin nitrides (8 and 6). A layer of oxide, for example, is deposited and etched to form spacers on the sidewalls of the opening which defines the substitute emitter. These spacers are then used as the mask for cutting the thin nitride in the areas where the thick thermally oxidised (LOCOS) regions are to be formed. The spacers are removed preferably using wet etching. A directional etch of nitride is then used to remove the thin nitride which was previously covered by the spacers. Subsequent processing is as above described in relation to Figure 2. The structure is shown in Figure 8.

## Claims

1. A method of fabricating a bipolar transistor comprising emitter, base and collector regions in a semiconductor substrate, the method comprising the steps of:

a) forming a layer of material over the substrate;

b) etching said layer of material to define a body on the substrate corresponding to the region which will subsequently become the base;

c) forming a layer of conductive material on the substrate about and in physical contact with said body;

d) producing base contacts in the substrate under the conductive material adjacent the site of the body;

e) etching to remove the body before or after step (d); and

f) inplanting the base region in the substrate through the opening left in the conductive layer by the removal of the body.

2. A method as claimed in claim 1 comprising the further steps of:

g) forming, non-lithographically, an annular body of dielectric around the inner periphery of the sidewall of the opening left in the conductive layer by the removal of the body;

h) depositing a further layer of a conductive material to contact the substrate within the inner periphery of said annular body; and

i) forming the emitter by driving a dopant from said further layer of conductive material into the substrate.

3. A method as claimed in claim 1 or claim 2 wherein said layer of material comprises silicon nitride.

4. A method as claimed in any one of the preceding claims wherein said layer of conductive material comprises polysilicon.

5. A method as claimed in any one of the preceding claims wherein said further layer of a conductive material comprises polysilicon.

6. A method substantially as hereinbefore described with reference to the accompanying drawings.

7. A bipolar transistor made according to the method of any one of the preceding claims.

8. A bipolar transistor substantially as hereinbefore described with reference to and as illustrated in any one of the accompanying drawings.

9. An integrated circuit comprising a plurality of bipolar transistors as claimed in claim 7 or claim 8.

Fig.1.

Fig.2.

Fig.3.

Fig.4.

Fig.5.

Fig.6.

Fig.7.

Fig.8.

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| Y | IBM TECHNICAL DISCLOSURE BULLETIN, vol. 25, no. 11B, April 1983, pages 6175-6176, New York, US; H.S. BHATIA et al.: "Polysilicon base-etched transistor" <br> * Whole document * | 1,2,4 | H 01 L 21/285 <br> H 01 L 21/82 <br> H 01 L 29/72 <br> H 01 L 27/08 |
| Y | EP-A-0 180 256 (N.V. PHILIPS' GLOEILAMPENFABRIEKEN) <br> * Page 3, line 16 - page 5, line 7; figure 3 * | 1,2,4 | |
| Y | IBM TECHNICAL DISCLOSURE BULLETIN, vol. 25, no. 3A, August 1982, pages 1189-1193, New York, US; L.M. EPHRATH et al.: "Self-aligned gate process using pattern transfer for high speed MESFET fabrication" <br> * Figure 1E; page 1191, section 2 * | 1,2,4 | |
| A | EP-A-0 170 250 (K.K. TOSHIBA) <br> * Claims 1,6; figure 8 * | 1,7 | TECHNICAL FIELDS SEARCHED (Int. Cl.4) |
| A | JAPANESE JOURNAL OF APPLIED PHYSICS, PROCEEDINGS OF THE 12TH CONFERENCE ON SOLID STATE DEVICES, Tokyo, 1980; vol. 20, 1981, supplement 20-1, pages 155-159; T. SAKAI et al.: "High speed bipolar ICs using super self-aligned process technology" | | H 01 L |

The present search report has been drawn up for all claims

| Place of search | Date of completion of the search | Examiner |
|---|---|---|
| THE HAGUE | 30-11-1987 | ZOLLFRANK G.O. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)